(19) **Europäisches Patentamt**

**European Patent Office**

**Office européen des brevets**

(11) **EP 1 575 099 A1**

(12) **EUROPÄISCHE PATENTANMELDUNG**

(43) Veröffentlichungstag:
14.09.2005 Patentblatt 2005/37

(51) Int Cl.7: **H01L 31/0224**, H01L 31/18,
H05K 1/09, H05K 3/12

(21) Anmeldenummer: 04005540.2

(22) Anmeldetag: 09.03.2004

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL LT LV MK**

(71) Anmelder: **RWE SCHOTT Solar GmbH**
**63755 Alzenau (DE)**

(72) Erfinder:
• **Schwirtlich, Ingo Dr.**
**63987 Miltenberg (DE)**
• **v.Campe, Hilmar Dr.**
**61352 Bad Homburg (DE)**

(74) Vertreter: **Stoffregen, Hans-Herbert**
**Patentanwalt,**
**Friedrich-Ebert-Anlage 11b**
**63450 Hanau (DE)**

(54) **Verfahren zum Ausbilden einer Struktur**

(57) Die Erfindung bezieht sich au ein Verfahren zum Ausbilden einer linien- und/oder punktförmigen Struktur auf einem Träger, insbesondere zum Ausbilden von streifenförmigen elektrisch leitenden Kontakten auf einem Halbleiterbauelement wie Solarzelle, durch Auftragen einer auf dem Träger haftenden elektrisch leitenden pastenförmigen Substanz und anschließendes Aushärten der Substanz. Um die Abschattung zu dem Träger zu minimieren und gleichzeitig den Widerstand der Struktur niedrig zu halten, wird vorgeschlagen, dass als Substanz eine solche mit elektrisch aktiven Zentren verwendet wird, dass nach Auftragen der Substanz auf den Träger auf diese ein polare Moleküle enthaltendes Medium aufgebracht wird und/oder dass als Substanz eine solche verwendet wird, die zumindest eine an der Oberfläche der Substanz unmittelbar nach Auftragen auf den Träger aushärtende Komponente enthält.

Printed by Jouve, 75001 PARIS (FR)

**Beschreibung**

Die Erfindung bezieht sich auf ein Verfahren zum Ausbilden einer linien- und/oder punktförmigen Struktur auf einem Träger, insbesondere zum Ausbilden von streifenförmigen elektrisch leitenden Kontakten auf einem Halbleiterbauelement wie Solarzelle, durch Auftragen einer auf dem Träger haftenden elektrisch leitenden pastenförmigen Substanz und anschließendes Aushärten der Substanz.

Bei der Herstellung elektronischer Bauelemente erfolgt das Aufbringen feiner elektrisch leitender Strukturen in erster Linie über physikalische oder chemische Gasphasenabscheidung, epitaktische Verfahren unter Verwendung von Masken oder eventuell mit zusätzlicher Laserunterstützung. Diese Techniken erlauben die Herstellung sehr feiner Strukturen, gleichwenn diese für eine kostengünstige Massenproduktion aus wirtschaftlichen Gründen kaum geeignet sind.

Andere Verfahren, um feine Strukturen aufzubringen, sind z. B. Siebdruck, Rollendruck oder Tampondruck. Auch wenn diese Verfahren unter wirtschaftlichen Gesichtspunkten attraktiv erscheinen, ist jedoch der Nachteil gegeben, dass nur eine begrenzte Auflösung der Strukturen erzielbar ist, so dass eine Verwendung grundsätzlich nur für größere e-lek- tronische Bauelemente mit gröberen Strukturen geeignet ist.

Bei der Herstellung von Solarzellen besteht hinsichtlich der strahlungszugewandten Seite die Anforderung, möglichst feine elektrisch leitende Strukturen aufzubringen, die eine gute elektrische Leitfähigkeit sowie einen guten elektrischen Kontakt zur Solarzelle, also zum Träger sicherstellen. Diese Forderung ergeht vor dem Hintergrund, dass die der Strahlung zugewandte Fläche so gering wie möglich abzuschatten ist. Um jedoch eine gute elektrische Leitfähigkeit mit hoher Stromableitung zu ermöglichen, müssen die entsprechenden Leiter einen großen Querschnitt aufweisen. Um diesen Forderungen zu genügen, werden nach dem Stand der Technik Kontakte häufig mittels Siebdruck aufgebracht. Voraussetzung hierfür ist jedoch, dass der Träger eine ebene Oberfläche aufweist, auf die die linien- bzw. streifenförmigen Kontakte aufgebracht werden. Auch epitaktische Verfahren gelangen zur Anwendung.

Bei einem weiteren bekannten Verfahren werden mittels eines Laserstrahls Vertiefungen in eine Solarzellenoberfläche eingebracht, die anschließend mittels chemischer Abscheideverfahren mit leitfähigem Material gefüllt werden (US 4,726,850). Allerdings ist ein entsprechendes Verfahren recht aufwendig und damit kostenträchtig.

Druckverfahren haben den grundsätzlichen Nachteil, dass bei geringer Linienbreite keine hohen Schichtdicken erzeugbar sind. Dies führt zu dem Nachteil, dass breitere Linien oder eine größere Anzahl dieser erforderlich sind, um die gewünschten niedrigen Widerstandswerte zu erzielen. Somit erfolgt eine unerwünschte Abschattung.

Fingerschreibsysteme, soweit diese bei der Strukturierung von Solarzellen zum Einsatz gelangen, sind grundsätzlich zur Erfüllung der Anforderungen geeignet. Allerdings hängt die Linienbreite stark von der Wechselwirkung der aufzubringenden Substanz, in der Regel in Form einer Paste, und den Oberflächeneigenschaften des Trägers ab. Paste und Träger beeinflussen das Ausbreiten ersterer nach dem Aufbringen im Wesentlichen. Dabei zeigen die aufgetragenen Strukturen linearer Streifen die Tendenz zu verlaufen. Hierdurch bedingt vergröbert sich die aufgebrachte Struktur. Um diese Nachteile zu vermeiden, können feine Öffnungen des Fingerschreibsystems gewählt werden, wodurch jedoch das Risiko erwächst, dass die aufzubringenden Streifen abreißen. Die hohe Sensibilität des Prozesses auf die relevanten Prozessparameter führt daher dazu, dass die entsprechende Technik nur selten Anwendung findet.

Der vorliegenden Erfindung liegt das Problem zu Grunde, ein Verfahren der eingangs genannten Art so weiterzubilden, dass elektrisch leitende Strukturen wie Leiterbahnen bzw. Kontakte auf einen Träger aufgebracht werden können, wobei die Abschattung zu dem Träger minimiert werden soll. Gleichzeitig soll der Widerstand der Struktur gering sein. Auch soll das Verfahren für eine Massenproduktion, insbesondere bei der Herstellung von elektrisch leitenden Kontakten auf einem Halbleiterelement wie Solarzelle geeignet sein.

Zur Lösung des Problems sieht die Erfindung im Wesentlichen vor, dass als pastenförmige Substanz eine solche mit elektrisch aktiven Zentren verwendet wird, dass nach Auftragen der Substanz auf den Träger auf diesem ein polare Moleküle enthaltendes Medium aufgebracht wird und/oder dass als Substanz ein solches verwendet wird, das zumindest eine zumindest Oberfläche unmittelbar nach Auftragen auf den Träger aushärtende Komponente enthält.

Dabei kann das pastenförmige Substanz auf den Träger z. B. mittels Siebdruck, Tampondruck, Sprühtechnik oder bevorzugterweise mittels Fingerschreibtechnik aufgebracht werden.

Nach einem Lösungsaspekt der Erfindung werden an der Oberfläche der aufgebrachten pastenförmigen Substanz elektrisch aktive Zentren erzeugt. Dies kann durch Zugabe kurzkettiger organischer Moleküle zu Binderkomponenten in der Substanz erfolgen, die radikale Enden besitzen und somit die Substanzoberfläche in gewünschter Weise modifizieren. Dabei konnte festgestellt werden, dass das Breiten-Höhenverhältnis der aufgebrachten Strukturen mit der pastenförmigen Substanz durch Modifizieren der Trägeroberfläche und die Wechselwirkung der Substanz, der Trägeroberfläche und dem weiteren Medium verändert werden kann. Bei dem weiteren Medium handelt es sich insbesondere um eine Lösung polarer Moleküle, die sowohl mit der Oberfläche der Substanz als auch der des Trägers wechselwirken.

Dabei kann durch Modifizieren der Oberfläche des Trägers, bei der es sich vorzugsweise um einen Leiter wie Halbleiter handelt, mit einer wenige Nanometer dicken Schicht, die gleichfalls elektrisch aktive Zentren aufweist, sowie durch weitere Zugabe einer polare Moleküle enthaltenden Lösung bewirkt werden, dass die pastenförmige Substanz kurz nach Auftragen auf den Träger in seinem Breiten-Höhenverhältnis im Querschnitt zugunsten größerer Höhen und geringerer Breiten verändert wird, so dass sich die gewünschte Feinheit der angestrebten punkt- oder linienförmigen Struktur einstellt. Durch die Oberflächenmodifikation der beteiligten Substanzen kann eine den Anforderungen entsprechende feine Struktur elektrisch leitender pastenförmiger Substanzen aufgebracht werden, wobei zum Auftragen Verfahren zur Anwendung gelangen, die dem Stand der Technik zu entnehmen sind, also Siebdruck, Tampondruck, Sprühtechnik oder insbesondere mittels Fingerschreibsystem. Somit kann bei hohem Durchsatz kostengünstig eine gewünschte feine Struktur auf einem Träger wie Solarzelle aufgebracht werden.

Eine Möglichkeit, die erforderliche Oberflächenmodifikation des Träger zu erreichen, kann durch Auftragen einer dünnen Oxid- und/oder Nitridschicht bewirkt werden, wobei die entsprechende Schicht in der Regel nicht stöchiometrisch zusammengesetzt sein muss. Durch zusätzliche gezielte Einwirkung von Feuchtigkeit, z. B. von feuchter Luft, kann die Stärke der elektrisch aktiven Oberflächenzentren zusätzlich beeinflusst werden. Hierdurch bedingt wird ein Fließen der pastenförmigen Substanz entlang Trägeroberfläche unterbunden bzw. eingeschränkt, so dass die gewünschten feinen Strukturen erreichbar sind. Anschließend erfolgt in gewohnter Weise ein Trocknen bzw. Sintern, um die Metallpartikel der Substanz in den Träger einzubrennen. Hierdurch sind die gewünschten elektrischen Eigenschaften der aufgebrachten Struktur sichergestellt.

Aufgrund der durch die erfindungsgemäße Lehre erzielbaren feinen Struktur, also schmalen Kontaktflächen zwischen pastenförmiger Substanz und Träger, ergibt sich nach dem Sintern ein Bereich auf dem Träger entlang der Substanzstruktur, der anfänglich, also vor dem Sintern mit der Substanz kontaktiert war, jedoch anschließend durch quasi Zusammenziehen der Substanz wieder freigelegt wird. Dieser zuvor abgedeckte und sodann wieder freigelegte Bereich ist optisch erfassbar und charakteristisch für die erfindungsgemäße Lehre.

Nach einem weiteren Lösungsaspekt der Erfindung kann die Reduzierung der Breite der auf den Träger aufgebrachten pastenförmigen Substanz auch dadurch erreicht werden, dass ein Zerfließen der Substanz durch Umwandlung des Substanzmaterials unterbunden bzw. verringert wird, indem der Substanz Komponenten zugegeben werden, die zumindest oberflächenseitig ein schnelles Aushärten mit der Folge ermöglichen, dass die aufgetragene Substanz überaus schnell formstabil ist. Hierdurch wird ein weiteres Zerfließen unterbunden.

Diese Formstabilität kann durch Bildung einer mechanisch stabilen Haut oder Kruste realisiert werden.

Als bevorzugte Möglichkeiten zur Oberflächenaushärtung, also zur Bildung der Haut oder Kruste sind folgende Maßnahmen zu nennen:

- chemische Umwandlungsreaktion an der Oberfläche mit einem Gasgemisch wie z. B. ozonhaltiger Luft oder einer Flüssigkeit wie z. B. Wasser oder einem Feststoff wie z. B. Polymerpulver mit Streuteilchen,
- Erzeugung einer Oberflächenreaktion mittels eines Katalysators, der mit Luft reagiert,
- Einwirkung durch elektromagnetische Strahlung wie Licht (UV-Härtung), elektromagnetische Hochfrequenzfelder oder IR-Strahlung und die hierdurch bedingte Erwärmung des Oberflächenbereichs des Substanz,
- vorzeitige Trocknung der Substanz durch Entzug von in diesem vorhandenen Lösungsmittel aus dem Oberflächenbereich.

Insbesondere wird jedoch das Zerfließen der pastenartigen Substanz dadurch unterbunden, dass nach Auftragen der Substanz das die polaren Moleküle enthaltende Medium auf den Träger aufgebracht wird, wobei dessen Adhäsionskräfte zum Träger größer als Adhäsionskräfte zwischen Substanz und Träger sind. Hierdurch bedingt wird ein Zer- bzw. Ausfließen der pastenförmigen Substanz gehemmt und diese sogar zurückgedrängt. Es zeigt sich ein quasi Zurückziehen der aufgebrachten Substanz mit der Folge, dass sich ein günstiges Höhen-Breitenverhältnis einstellt.

Allerdings ist darauf zu achten, dass die Adhäsionskräfte zwischen dem Medium und dem Träger bzw. der Substanz und dem Träger derart aufeinander abgestimmt werden, dass eine Unterwanderung der Substanz unterbleibt, da anderenfalls ein Ablösen der Substanz vom Träger erfolgen könnte. Somit muss sichergestellt sein, dass eine hinreichend gute Adhäsion der Substanz zum Träger gegeben ist. Gleichzeitig soll jedoch eine hinreichend schnelle Aushärtung der Oberfläche der Substanz erfolgen, wobei ein haftender Kembereich verbleiben soll.

Mit anderen Worten ist durch das Einsetzen des Mediums bzw. das Hinzufügen der aushärtenden Komponenten sicherzustellen, dass ein Zerfließen der pastenförmigen Substanz nach Auftragen auf den Träger unterbunden wird, gleichzeitig jedoch eine hinreichende Haftung auf dem Träger sichergestellt ist, wobei gegebenenfalls ohne Einbußen des Kontaktes ein Zusammenziehen der Substanz ermöglicht werden soll.

Bei dem Träger handelt es sich insbesondere um ein Metall, bevorzugter Weise um ein Halbleitermaterial wie ein- und/oder multikristallines Silizium, Germanium, eine dünne Schicht aus amorphem Silizium oder Verbindungshalbleitern wie Cadmium-Tellurid oder Kupfer-Indium-Diselenid. Diese Materialien werden als Grundmaterial für die Herstellung von Solarzellen verwendet. Dabei ist es ein Hauptaspekt der Erfindung, feine metallische Strukturen auf der strahlungszugewandten Seite von Solarzellen bei geringer Abschattung und somit höherem Wirkungsgrad bei der Umwandlung von Licht in elektrische Energie zu erzielen. Allerdings soll hierdurch die erfindungsgemäße Lehre nicht eingeschränkt werden. Vielmehr lässt sich das erfindungsgemäße Verfahren auch zur Erzeugung feiner elektrisch leitfähiger Strukturen auf Isolatoren wie Glas-oder Keramiksubstanzen zur Anwendung bringen. Beispielhaft ist die Verwendung derartiger Strukturen zur Beheizung flächiger Träger zu nennen. Als Träger sind auch mit Isolationsschichten versehene metallische Materialien zu nennen, auf denen unter Zugrundelegung der erfindungsgemäßen Lehre elektrische Komponenten verschaltet werden können.

Die pastenförmige Substanz besteht im Wesentlichen aus einem oder mehreren Harzen, einem oder mehreren Lösungsmitteln sowie metallischen Pulvern wie Silber, Aluminium oder Blei als Sinterhilfe sowie Glas als Haftvermittler zum Träger. Die Substanz kann erwähntermaßen mittels Siebdruck, Fingerschreibgerät, Tampondruck etc. auf die Oberfläche des Trägers aufgetragen werden. Erfolgt ein gutes Benetzen der Trägeroberfläche, also bei guter Adhäsion zwischen der Substanz und dem Träger, so tritt nach dem Stand der Technik ein Ausfließen - auch Ausbluten genannt - der Substanz auf, so dass die Tendenz zur Verbreiterung der aufgetragenen Struktur wie Linien bzw. Streifen gegeben ist. Nach dem Stand der Technik kann dieser Verbreiterungstendenz durch Einstellung einer hohen Substanzviskosität teilweise entgegengewirkt werden. Dabei können thixotrope Pasten verwendet werden, deren Viskosität bei Anlegen einer Scherkraft herabgesetzt wird, im kräftefreien Zustand jedoch stark zunimmt.

Demgegenüber ist nach einem Teilaspekt der Erfindung vorgesehen, dass das Ausfließen bzw. Ausbluten dadurch unterbunden bzw. eingedämmt wird, dass ein weiteres Medium wie Flüssigkeit oder eine solche enthaltend auf die Trägeroberfläche aufgebracht wird. Bei dem Medium handelt es sich insbesondere um eine Flüssigkeit oder einen Schaum. Ein Aerosol ist gleichfalls denkbar. Um die Adhäsion zum Träger zu erhöhen, ist dem Medium vorzugsweise ein Tensid beigemischt. Wird die Adhäsion des Mediums zum Träger größer als die der pastenförmigen Substanz zum Träger, wird die Substanz zurückgedrängt und ein Zerfließen bzw. Ausbluten unterbunden.

Um jedoch ein zu starkes Zurückdrängen der pastenförmigen Substanz zu unterbinden, wodurch es gegebenenfalls zu einer Tropfenbildung letzterer kommen könnte, kann die pastenförmige Substanz Bestandteile aufweisen, die mit dem Medium chemisch reagieren, um eine mechanisch stabile Oberfläche oder Haut auszubilden. Diese Haut stabilisiert die Form der pastenförmigen Substanz und verhindert somit eine Tropfenbildung. Im Inneren der pastenförmigen Substanz bleibt jedoch unreagiertes Material zurück, wodurch die Haftung der pastenförmigen Substanz an der Oberfläche des Trägers aufrechterhalten wird.

Bei dünn aufgetragenen Strukturen wie Leiterbahnen mit Durchmessern von z. B. 100 µm kann sogar eine Reaktion bis zum Kern der Substanz erfolgen, so dass eine komplette Härtung erzielt wird. Diese Härtung führt zu einer stabilen Form innerhalb weniger Sekunden. Erwähntermaßen muss jedoch darauf geachtet werden, dass die Haftung zwischen der Substanz und dem Träger beibehalten wird, da andernfalls eine Ablösung erfolgen würde.

Für das Aspektverhältnis Höhe : Breite der pastenförmigen Substanz sind Adhäsionskräfte, Kohäsionskräfte und Fließkräfte der Substanz ausschlaggebend. Eine wesentliche Rolle spielen dabei die Adhäsionskräfte zwischen der Substanz und Oberfläche des Trägers. Entscheidend hierfür sind die organischen Komponenten der Substanz wie Harze sowie Lösungsmittel.

Weitere Einzelheiten, Vorteile und Merkmale der Erfindung ergeben sich nicht nur aus den Ansprüchen, den diesen zu entnehmenden Merkmalen, sondern auch anhand der im Zusammenhang mit den der Zeichnung zu entnehmenden Ausführungsbeispielen sowie den zugehörigen Erläuterungen.

Es zeigen:

Fig. 1 einen Querschnitt durch eine linienförmige Struktur, hergestellt aus einer pastenförmigen Substanz,

Fig. 2 eine Draufsicht auf einen Träger mit auf diesem haftender linienförmiger Struktur,

Fig. 3 eine Prinzipdarstellung der auf einen Träger aufgebrachten linienförmigen Struktur nach dem Auftragen auf einen Träger bzw. nach dem Sintern gemäß Fig. 2 und

Fig. 4 einen Graph zur Verdeutlichung des Höhen-Breitenverhältnisses aufgetragener Strukturen.

Die erfindungsgemäße Lehre wird bevorzugterweise zur Verbesserung des Wirkungsgrades von Solarzellen auf der Basis von kristallinen Silizium-Substanzen verwendet, ohne dass hierdurch jedoch eine Einschränkung erfolgen soll.

Siliziumscheiben, die mit einer Oberflächenschicht aus $SiO_x$ mit $x \le 2$, oder $Si_3N_x$ mit $x \le 4$ versehen sind, die der Reduzierung der Reflektion auf einer Strahlung dienen, werden Luft bzw. feuchter Luft ausgesetzt. Im Anschluss an eine derartige Behandlung ist eine Aktivierung der Trägeroberfläche festzustellen, die mit der Erzeugung elektrisch aktiver Zentren an Bindungen des Siliziums bzw. des $Si_3N_x$ erklärt werden können. Die entsprechende Behandlung erfolgt bevorzugterweise bei einer Temperatur T mit in etwa 30° C ≤ T ≤ in etwa 60° C über einen Zeitraum t in bevorzugterweise in etwa 15 Minuten ≤ t ≤ in etwa 90 Minuten. Die relative Luftfeuchtigkeit sollte zwischen 40 % und 90 % liegen. Alternativ kann eine Aktivierung der Oberfläche des Trägers, also der Solarzelle durch Exposition gegenüber einer ozonhaltigen Atmosphäre oder durch zusätzliche Behandlung mit UV-Licht verstärkt werden. Eine verstärkende Wirkung kann auch durch anschließende oder parallele Behandlung mit einer Koronaentladung erreicht werden.

Auf die entsprechend behandelte Oberfläche des Trägers, also im Ausführungsbeispiel der Solarzelle wird eine pastenförmige Substanz - nachstehend kurz Paste genannt - aufgetragen. Nach einem Aspekt der erfindungsgemäßen Lehre weist die elektrisch leitende Paste kurzkettige organische Substanzen auf, die über ein stärker elektronegatives Ende verfügen. Hierdurch wird die Paste in einen Zustand versetzt, der es ermöglicht, die durch die elektronegativen Enden bedingte Oberflächenladung der Paste nach Aufbringen auf den Träger in Wechselwirkung mit der aktivierten Schicht auf den Träger zu bringen. Je nach Einstellung der Paste, d. h. Stärke der Wechselwirkung, neigt diese dazu, auf der Substanz auseinander zu laufen, oder zu einer geringen Kontaktfläche. Das Auseinanderlaufen der Paste erfolgt aufgrund eines kleinen Benetzungswinkels zwischen der Paste und Trägeroberfläche. Ohne zusätzliche Maßnahmen würde dies zu einer ungewollt breiten metallischen Struktur führen, die allerdings gute Haftungseigenschaften zur Trägeroberfläche aufweisen würde. Ein Zerfließen der Paste würde dann unterbunden werden, wenn sich zwischen der Paste und dem Träger abstoßende Kräfte ausbilden, wodurch ein großer Benetzungswinkel entstehen würde, der dazu führt, dass die aufgetragenen Strukturen aufgrund mangelnder Haftung sich ablösen können.

Erfindungsgemäß wird durch Zugabe eines weiteren Mediums einerseits das Zerfließen unterbunden bzw. eingedämmt und andererseits ein Lösen der Paste von dem Träger verhindert, so dass schmale Strukturen erzielbar sind. Das Medium wechselt mit der Paste derart, dass einerseits ein Zusammenziehen der aufgebrachten Pastenstruktur erfolgt, andererseits die Festigkeit zu dem Träger nicht nachteilig beeinflusst wird.

Als Medium wird insbesondere eine Flüssigkeit, bevorzugterweise ein Schaum verwendet, die bzw. der unmittelbar nach Auftragen der Paste auf den Träger aufgebracht wird. Dabei weist das Medium eine Zusammensetzung derart auf, dass die Adhäsionskräfte zwischen diesem und dem Träger größer als die Adhäsionskräfte zwischen der Paste und dem Träger sind. Hierdurch bedingt wird durch das Medium die Paste quasi zurückgedrängt mit der Folge, dass einem Auseinanderfließen entgegengewirkt wird. Dabei konnte sogar festgestellt werden, dass die Struktur aufgrund der wirkenden Adhäsionskräfte in der Breite verringert wird, also die Paste in ihrer Breite verschmälert wird.

Alternativ oder zusätzlich kann die Paste Komponenten enthalten, die bewirken, dass nach dem Auftragen der Paste auf den Träger zumindest eine Oberflächenhärtung mit der Folge eintritt, dass ein Verbreitern unterbunden wird, da die aufgetragene Paste, also deren Geometrie, durch die Oberflächenaushärtung beibehalten wird.

Die Paste kann aus mehreren organischen Komponenten wie Harzen und Lösungsmitteln, verschiedenen Bindern und Dispergiermitteln in fester und/oder flüssiger Form sowie organischen Feststoffen wie z. B. einem Gemisch aus Metallen wie Kupfer, Silber, Aluminium, Blei, Zinn, Lotlegierungen sowie Kombinationen hieraus und aus Kombination anderer, auch nicht-metallischer Stoffe wie Aerosole aus Siliziumoxid, Siliziumnitrid, Zinkoxid, Ruß-/Graphitteilchen bzw. diese Komponenten enthaltenden Pulvern sowie anorganischen Sinterhilfen zusammengesetzt sein. Ferner können niedrigschmelzende Glaslegierungen oder anorganische Substanzen wie Glas, bleihaltiges Glas, Bor- oder Phosphorsilikatglas, oder Metalloxide als Sinterhilfe, Schmelzpunkterniedriger, Haftvermittler während des Sinterprozesses, Flussmittel etc. der Paste zugegeben werden.

Ferner werden organische Komponenten wie Polymere (Harze) und organische Lösungsmittel hinzu gegeben. Insbesondere können die organischen Komponenten einer Paste enthalten:

- Binder wie Acryl- und Polyesterharze, Chloropene, Ethylcellulose, Ethylene, Polyethylene, Furane, Polyvinylchlorid, Alkydharze, Epoxidharze, Epoxidester, Polyurethane, Butadiene, Silikone und Mischungen daraus,
- Lösungsmittel wie Dimethylester, Butylester, Wasser, Alkohole, Ethanol, Propanol, Butanol, Aceton, Terpentin, Benzol, Benzin,
- Vernetzungsmittel wie Melamine, Phenolharze, Benzoguanamine, Harnstoffvernetzer,
- Härter,
- Schichtbildner wie Polyvinylbutyral,
- Benetzungsmittel,
- rheologische Komponenten,
- Polymer-Modifikatoren wie Plasticizer.

Beispielhaft kann die Paste aus einem Binder Ethylzellulose gelöst in Buthyldiglykol, verschiedenen Bindern unterschiedlicher Kettenlängen und Zusätzen, die einen Einfluss auf die Fließfähigkeit der Paste besitzen sollen, bestehen. Eine entsprechende in geeigneter Viskosität eingestellte Paste kann nach einem gewünschten Aufbringungsverfahren wie Siebdruck, Schablonendruck oder Fingerschreibverfahren auf den Träger wie der Solarzelle aufgetragen werden.

Erfolgt ein Auftragen nach der Fingerschreibtechnologie, so besitzt die Paste zunächst einen kreisförmigen Querschnitt. Durch die Bewegung des Trägers relativ zur Austrittsdüse des Fingerschreibsystems wird die Paste in die Länge gezogen. Dabei sollen Viskosität der Paste und Geschwindigkeit des Vorschubs des Trägers so eingestellt werden, dass sich ein Pastenfaden mit einem Durchmesser zwischen 50 μm und 300 μm, vorzugsweise 80 μm ergibt. Selbstverständlich können auch das Fingerschreibsystem zu dem Träger oder diese zueinander bewegt werden.

Um das ansonsten auftretende unerwünschte Verbreitern des Streifens zu unterbinden, erfolgen innerhalb der ersten Sekunden nach dem Auftragen erfindungsgemäß vorgeschlagene Maßnahmen. So kann der Träger bzw. der Pastenstreifen unmittelbar nach dessen Auftragen auf den Träger in Kontakt gebracht werden mit:

- einem Feststoff wie einem feinen Pulver, das das Lösungsmittel an der Pastenoberfläche bindet und eine verschließbare Haut bildet,
- einer Flüssigkeit oder einem Gas, entweder allein oder in Kombination, die bzw. das mit dem Lösungsmittel oder dem Harz der Paste reagiert,
- elektrischen Entladungen, die ein Plasma erzeugen, das zur Oberflächenhärtung der Paste führt,
- elektromagnetischer Strahlung wie Kunststoff härtendes UV-Licht oder IR-Strahlung mit schnelltrocknender Wirkung, um die Oberfläche auszuhärten.

Insbesondere wird der Pastenstreifen unmittelbar nach seinem Auftragen auf den Träger mit einer Wasser enthaltenden Flüssigkeit wie Schaum in Kontakt gebracht. Der Schaum löst aus dem Pastenmaterial das organische Lösungsmittel heraus und bewirkt dadurch eine mechanische Veränderung wir Härtung der Oberfläche. Die Oberfläche bildet somit eine zähe Haut aus, so dass ein weiteres Ausfließen des Pastenmaterials verhindert wird. Zusammen mit dem Feststoffgehalt der Paste bildet sich eine feste Kruste.

Im Ausführungsbeispiel wird das organische und zugleich wasserlösliche Lösungsmittel Butyldiglykol durch den Kontakt mit den Medien wie tensidhaltiger Wasserlösung zu 80 bis 100 % entfernt. Dies führt zu einer Oberflächenhärtung wie Krustenausbildung.

Werden z. B. Stege einer Breite von 100 μm aufgetragen, so kann eine durchgehende Härtung auftreten. Um zu vermeiden, dass der komplett gehärtete Steg von dem Träger abgelöst wird, werden erfindungsgemäß neben den wasserlöslichen Lösungsmitteln auch wasserunlösliche Lösungsmittel zugegeben, wodurch einerseits die gewünschte Aushärtung erfolgt und andererseits die Haftungseigenschaften zum Träger beibehalten werden.

Erfindungsgemäß werden folglich härtende und nicht härtende Harz-Lösungsmittelgemische unter Zumischung von Metallpulvern zu Pasten verarbeitet, die in den Randbereichen einer Kontaktstelle zu dem Medium wie Wasser enthaltender Flüssigkeit oder Schaum aushärten. Die Komponenten der Pasten werden so zusammengemischt, dass ein Teil der Paste ein wasserlösliches Lösungsmittel, der andere Teil ein wasserunlösliches Lösungsmittel enthält. Nach Auftragen der Pastenmischung führt die Reaktion mit dem Medium wie Schaum zur Austragung von wasserlöslichem Lösungsmittel aus Teilbereichen der Paste und damit zur Härtung. Die anderen Teile der Paste bleiben unverändert, und zwar diejenigen, die wasserunlösliche Lösungsmittel enthalten, und stellen somit die Hafteigenschaften zu dem Träger sicher.

Nach einem weiteren Vorschlag der Erfindung kann der Paste eine UV-härtende Komponente zugegeben werden. Das Auftragen der Paste auf den Träger wird unter Einwirkung von UV-Licht durchgeführt, wodurch eine Härtung der Paste in ihrer Oberfläche erfolgt. Im Inneren der Paste verbleibt ein weicher Kern, der die ursprünglichen Haftungseigenschaften ermöglicht. Die Eindringtiefe des UV-Lichtes liegt je nach Absorptionseigenschaften der organischen Haftmischung im Bereich von 100 nm bis 1 μm, wobei durch die Metallpartikel in der Paste ein weiteres Eindringen der Strahlung verhindern wird.

Nach Auftragen der punkt-, linien- bzw. streifenförmigen Paste und deren erfindungsgemäße Beeinflussung zum Vermeiden eines Aus- bzw. Zerfließens erfolgt in gewohnter Weise ein Trocknen und anschließendes Sintern.

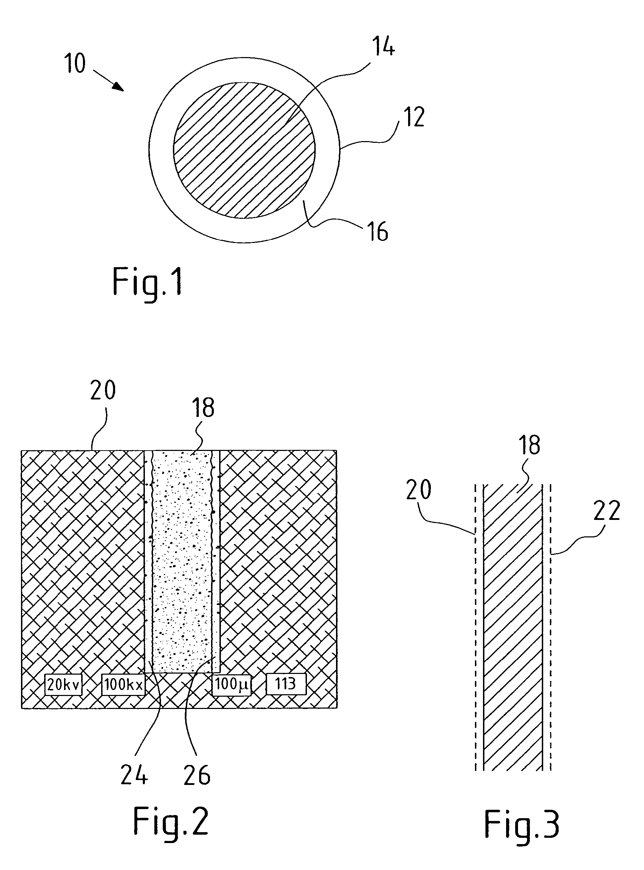

Untersucht man erfindungsgemäß auf einem Träger aufgebrachte Strukturen, so ist festzustellen, dass die Abdeckung der ursprünglich auf einem Träger aufgebrachten Paste nach dem Sinterprozess eine geringere Fläche des Trägers abdeckt als unmittelbar nach dem Auftragen auf diesen. Dies sei anhand der Fig. 1 bis 3 verdeutlicht.

So ist in Fig. 1 eine Prinzipdarstellung einer auf einem Träger aufgebrachten punktförmigen Struktur 10 wiedergegeben. Die Fläche, die die Paste unmittelbar nach Auftragen auf den Träger abdeckt, ist durch den äußeren Kreis 12 symbolisiert. Durch das unmittelbar nach dem Auftragen der Paste auf den Träger aufgebrachte Medium, insbesondere in Form eines tensidhaltigen Schaums, wird die Paste von dem Träger zurückgedrängt, so dass die Struktur nach dem Sintern eine in Fig. 1 schattiert dargestellte Fläche 14 abdeckt. Auf dem Träger selbst ist sodann ein schwacher, die Struktur 14 umgebender Ring 16 erkennbar, der ursprünglich vom Pastenmaterial bedeckt war. Durch das erfindungsgemäße Verfahren erfolgt eine Verfeinerung der punktförmigen Struktur.

Gleiches gilt in Bezug auf eine linienförmig aufgebrachte Struktur 18, wie die Fig. 2 und 3 verdeutlichen. Fig. 2 ist eine Fotografie eines auf einer Solarzelle 20 aufgebrachten pastenförmigen Streifens, dessen Breite nach dem Sintern dem schraffierten Bereich 18 gemäß Fig. 3 entspricht. Ursprünglich weist der Streifen eine Breite auf, der in Fig. 3 durch die gestrichelten Linien 20, 22 und in Fig. 2 durch die Streifen 24, 26 zuzüglich der Endstruktur 18 verdeutlicht wird.

Anhand der Fig. 3 sollen die Unterschiede zwischen auf einem Träger aufgebrachten streifenförmigen Strukturen nach dem Stand der Technik und der erfindungsgemäßen Lehre noch einmal verdeutlicht werden.

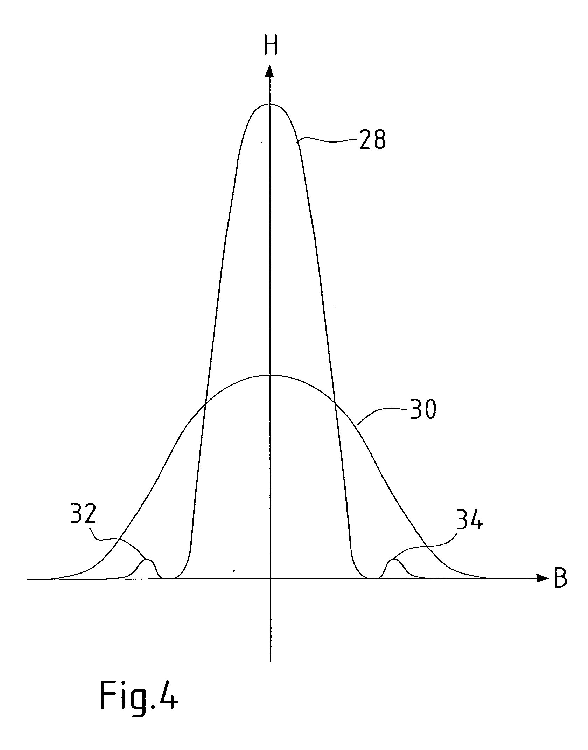

So ist in Fig. 4 Höhe und Breite von auf einer Siliziumsolarzellenoberfläche als Träger aufgebrachten streifenförmigen Kontakten dargestellt, wobei die Kurve 28 einen Kontakt symbolisiert, der nach der erfindungsgemäßen Lehre aufgetragen worden ist und die Kurve 30 einen solchen Stand der Technik. Die Einheiten von Höhe H und Breite B sind in Ordinaten und Abszisse unterschiedlich gewählt.

Der mit einem Fingerschreibverfahren auf die Siliziumsolarzelle aufgetragene Kontakt 28 weist eine Breite von in etwa 50 bis 200 µm, vorzugsweise 90 bis 110 µm bei einer Höhe H von 5 µm bis 50 µm, vorzugsweise 30 µm auf. Die nach dem Sintern auf der Solarzellenoberfläche feststellbaren Seitenstrukturen 32, 34, die in Fig. 2 den Streifen 24, 26 entsprechen, weisen einen Abstand von in etwa 150 µm bei einer Höhe zwischen 0,2 bis 200 µm auf.

Das Aspektverhältnis zwischen Höhe und Breite reicht von 0,1 bis in etwa 1 und beträgt typischerweise

$$33 \ \mu m : 110 \ \mu m = 0,3.$$

Der im Siebdruckverfahren auf einer Siliziumsolarzelle konventionell aufgebrachte Kontakt 30 weist demgegenüber eine Breite von etwa 50 bis 300 µm, vorzugsweise 200 µm auf. Die Steghöhe beläuft sich zwischen 5 µm bis 25 µm. Somit ergibt sich ein Aspektverhältnis von Höhe zu Breite zwischen 0,02 bis 0,2 und liegt typischerweise bei

$$14 \ \mu m : 200 \ \mu m = 0,07 \ .$$

Aufgrund der erfindungsgemäßen Lehre kann durchschnittlich eine Verfeinerung der Linienbreite um 20µm bis 50 µm gegenüber ursprünglicher Auftragbreite erzielt werden. Charakteristisch sind die Seitenstrukturen, die auf das Zusammenziehen des Streifens zurückzuführen sind.

Das erfindungsgemäße Verfahren lässt sich grundsätzlich für verschiedene Materialpaarungen verwenden, bei denen eine Struktur mittels metallhaltiger Pasten auf metallischen Substanzen aufgebracht und eine Linienbreite von ≤ 150 µm erzeugt werden soll. Dies gilt insbesondere auch für abgeschiedene Halbleiterschichten auf amorphem Silizium, Cadmium-Tellurid-Verbindungen oder Kupfer-Indium-Diselenid-Verbindungen auf Glasträgern, die zuvor mit einer leitfähigen Schicht bedeckt worden sind.

**Patentansprüche**

1. Verfahren zum Ausbilden einer linien- und/oder punktförmigen Struktur auf einem Träger, insbesondere zum Ausbilden von streifenförmigen elektrisch leitenden Kontakten auf einem Halbleiterbauelement wie Solarzelle, durch Auftragen einer auf dem Träger haftenden elektrisch leitenden pastenförmigen Substanz und anschließendes Aushärten der Substanz,
   **dadurch gekennzeichnet,**
   **dass** als Substanz eine solche mit elektrisch aktiven Zentren verwendet wird, dass nach Auftragen der Substanz auf den Träger auf diesem ein polare Moleküle enthaltendes Medium aufgebracht wird und/oder dass als Substanz eine solche verwendet wird, die zumindest eine an der Oberfläche der Substanz unmittelbar nach Auftragen auf den Träger aushärtende Komponente enthält.

2. Verfahren nach Anspruch 1,
   **dadurch gekennzeichnet,**
   **dass** das Medium in einem Umfang auf den Träger aufgegeben wird, dass ein Fließen der Substanz entlang des Trägers unter Vermeidung eines Lösens der Substanz von dem Träger unterbunden oder weitgehend unterbunden wird.

3. Verfahren nach Anspruch 1 oder 2,
   **dadurch gekennzeichnet,**
   **dass** Adhäsionskräfte zwischen dem Medium und dem Träger größer als Adhäsionskräfte zwischen der Substanz und dem Träger sind.

4. Verfahren nach zumindest einem der vorhergehenden Ansprüche,
   **dadurch gekennzeichnet,**
   **dass** als Medium ein tensidisches Medium verwendet wird.

5. Verfahren nach zumindest einem der vorhergehenden Ansprüche,
   **dadurch gekennzeichnet,**
   **dass** das tensidische Medium in Form einer Flüssigkeit oder eines Schaums im Bereich der aufgetragenen pastenförmigen Substanz auf den Träger aufgebracht wird.

6. Verfahren nach zumindest einem der vorhergehenden Ansprüche,
   **dadurch gekennzeichnet,**
   **dass** als Medium ein solches verwendet wird, das in der pastenförmigen Substanz vorhandene Lösungsmittel löst.

7. Verfahren nach zumindest einem der vorhergehenden Ansprüche,
   **dadurch gekennzeichnet,**

**dass** die pastenförmige Substanz ein Medium enthält und/oder nach Auftragen der pastenförmigen Substanz ein Medium auf den Träger und/oder die Substanz aufgebracht wird, durch das ein Zusammenziehen der Substanz nach Auftragen auf den Träger erfolgt.

8. Verfahren nach zumindest einem der vorhergehenden Ansprüche,
   **dadurch gekennzeichnet,**
   **dass** das Medium ein Abstoßen der Substanz von dem Träger in einem Umfang bewirkt, dass ein Fließen der Substanz entlang des Trägers zumindest eingeschränkt wird bei gleichzeitiger bleibender haftender Verbindung zwischen der Substanz und dem Träger.

9. Verfahren nach zumindest einem der vorhergehenden Ansprüche,
   **dadurch gekennzeichnet,**
   **dass** die pastenförmige Substanz auf den Träger vorzugsweise mittels Siebdruck, Tampondruck, Fingerschreibtechnik und/oder Sprühtechnik aufgebracht wird.

10. Verfahren nach Anspruch 1, wobei das Medium auf den Träger aufgebracht wird,
    **dadurch gekennzeichnet,**
    **dass** das Medium innerhalb eines Zeitintervall $\Delta t$ nach Auftragen der Substanz auf den Träger aufgebracht wird.

11. Verfahren nach zumindest einem der vorhergehenden Ansprüche,
    **dadurch gekennzeichnet,**
    **dass** das Zeitintervall $\Delta t$ in etwa 0,1 sec bis in etwa 600 sec, vorzugsweise in etwa 1 sec bis in etwa 60 sec beträgt.

12. Verfahren nach zumindest einem der vorhergehenden Ansprüche,
    **dadurch gekennzeichnet,**
    **dass** als die elektrisch leitende pastenförmige Substanz eine solche mit kurzkettigen organischen Molekülen mit stark elektronegativen Enden verwendet wird.

13. Verfahren nach zumindest einem der vorhergehenden Ansprüche,
    **dadurch gekennzeichnet,**
    **dass** als Substanz eine solche bestehend aus einer oder mehreren organischen Komponenten wie Harzen und Lösungsmitteln, verschiedenen Bindern und Dispergiermitteln in fester und/oder flüssiger Form sowie organischen Feststoffen, wie z. B. einem Gemisch aus Metallen, wie Kupfer, Silber, Aluminium, Blei, Zink, Lotlegierungen und/oder Kombinationen hieraus und/oder in Kombination mit weiteren nichtmetallischen Stoffen wie Aerosole aus z. B. Siliziumoxid, Siliziumnitrid, Zinkoxid, Ruß/Graphit-Teilchen bzw. deren Komponenten enthaltende Pulver und/oder organische Sinterhilfen verwendet wird.

14. Verfahren nach zumindest einem der vorhergehenden Ansprüche,
    **dadurch gekennzeichnet,**
    **dass** der Substanz niedrigschmelzende Glaslegierungen oder anorganische Substanzen wie Glas, bleihaltiges Glas, Bor- oder Phosphorsilikatglas, Metalloxide als Sinterhilfe, Schmelzpunkterniedriger, Haftvermittler während des Sinterprozesses und/oder Flussmittel zugegeben werden.

15. Verfahren nach zumindest einem der vorhergehenden Ansprüche,
    **dadurch gekennzeichnet,**
    **dass** der Substanz organische Komponenten wie Polymere und/oder organische Lösungsmittel zugegeben werden.

16. Verfahren nach zumindest einem der vorhergehenden Ansprüche,
    **dadurch gekennzeichnet,**
    **dass** der Substanz eine oder mehrere organische Komponenten hinzugegeben werden:

    Binder wie Acryl- und Polyesterharze, Chloropene, Ethylcellulose, Ethylene, Polyethylene, Furane, Polyvinylchloride, Alkydharze, Epoxidharze, Epoxidester, Polyurethane, Butadiene, Silkone und Mischungen daraus und/oder Lösungsmittel wie Dimethylester, Butylester, Wasser, Alkohole, Ethanol, Propanol, Butanol, Aceton, Terpentin, Benzol, Benzin und/oder Vernetzungsmittel wie Melamine, Phenolharze, Benzoguanamine, Hamstoffvernetzer und/oder
    Härter und/oder
    Schichtbildner wie Polyvinylbutyral und/oder
    Benetzungsmittel und/oder
    rheologische Komponenten und/oder
    Polymer-Modifikatoren wie Plasticizer.

17. Verfahren nach zumindest einem der vorhergehenden Ansprüche,
    **dadurch gekennzeichnet,**
    **dass** die Substanz derart auf den Träger aufgebracht wird, dass sich ein Durchmesser d mit insbesondere 15 µm $\leq$ d $\leq$ 300 µm, vorzugsweise von in etwa 80 µm ergibt.

18. Verfahren nach zumindest einem der vorhergehenden Ansprüche,
    **dadurch gekennzeichnet,**
    **dass** der Substanz wasserlösliche und wasserunlösliche Lösungsmittel zugegeben werden.

**19.** Verfahren nach zumindest einem der vorhergehenden Ansprüche,
**dadurch gekennzeichnet,**
**dass** der Substanz eine UV-härtende Komponente zugegeben wird.

**20.** Verfahren nach zumindest einem der vorhergehenden Ansprüche,
**dadurch gekennzeichnet,**
**dass** die Substanz durch chemische Umwandlungsreaktion und/oder Oberflächenreaktion mittels eines mit Luft reagierenden Katalysators und/oder Einwirkung durch elektromagnetische Strahlung und/oder Entzug von Lösungsmittel oberflächengehärtet wird.

**21.** Verfahren nach zumindest einem der vorhergehenden Ansprüche,
**dadurch gekennzeichnet,**
**dass** die Substanz derart punkt- bzw. linien- oder streifenförmig auf den Träger aufgetragen wird, dass die ausgehärtete Substanz ein Höhen- zu Breitenverhältnis a mit insbesondere $0{,}1 \leq a \leq 1{,}0$, insbesondere a in etwa 0,3 aufweist.

**22.** Verfahren nach zumindest einem der vorhergehenden Ansprüche,
**dadurch gekennzeichnet,**
**dass** der Substanz härtende und nicht härtende Harz-Lösungsmittelgemische, gegebenenfalls unter Zumischung von Metallpulvern zugegeben wird.

**23.** Verfahren nach zumindest einem der vorhergehenden Ansprüche,
**dadurch gekennzeichnet,**
**dass** der Träger ein Siliziumsubstanz mit einer Oberflächenschicht aus $SiO_x$ mit $x \leq 2$ oder $Si_3O_x$ mit $x \leq 4$ verwendet wird.

**24.** Verfahren nach zumindest einem der vorhergehenden Ansprüche,
**dadurch gekennzeichnet,**
**dass** die Oberflächenschicht aus $SiO_x$ bzw. aus $Si_2N_x$ Luft bzw. feuchter Luft ausgesetzt wird.

**25.** Verfahren nach zumindest einem der vorhergehenden Ansprüche,
**dadurch gekennzeichnet,**
**dass** die $SiO_x$ bzw. $Si_3M_x$-Schicht bei einer Temperatur T mit $30\,°C \leq T \leq 60\,°C$ der feuchten Luft ausgesetzt wird.

**26.** Verfahren nach zumindest einem der vorhergehenden Ansprüche,
**dadurch gekennzeichnet,**
**dass** die $SiO_x$ bzw. $Si_3N_x$-Schicht über einen Zeitraum t mit $15\,min \leq t \leq 90\,min$ der feuchten Luft ausgesetzt wird.

**27.** Verfahren nach zumindest einem der vorhergehenden Ansprüche,
**dadurch gekennzeichnet,**
**dass** die $SiO_x$ bzw. $Si_3N_x$-Schicht einer Luft mit einer relativen Feuchtigkeit zwischen insbesondere 40 bis 90 % ausgesetzt wird.

Fig.1

Fig.2

Fig.3

Fig.4

**Europäisches**
**Patentamt**

**EUROPÄISCHER RECHERCHENBERICHT**

Nummer der Anmeldung

EP 04 00 5540

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | WO 93/24934 A (FIRST CLASS SECURITIES LIMITED ; SLIFKIN MICHAEL ARTHUR (GB); HAMPSHIR) 9. Dezember 1993 (1993-12-09)<br><br>* Seite 1 - Seite 6 *<br>----- | 1,7,9, 13, 15-17, 19,20,22 | H01L31/0224 H01L31/18 H05K1/09 H05K3/12 |
| X | US 6 322 620 B1 (XIAO YUE) 27. November 2001 (2001-11-27)<br><br>* das ganze Dokument *<br>----- | 1,9,13, 15,16, 20,22 | |
| X | US 6 312 864 B1 (KAWANA OSAMU ET AL) 6. November 2001 (2001-11-06)<br><br><br>* Spalte 6, Zeile 41 - Spalte 11, Zeile 55; Abbildung 3 *<br>----- | 1,2, 8-10, 13-16, 20,22 | |
| A | EP 1 119 007 A (MURATA MANUFACTURING CO) 25. Juli 2001 (2001-07-25)<br>* das ganze Dokument *<br>----- | 1,9, 13-16,22 | RECHERCHIERTE SACHGEBIETE (Int.Cl.7) |
| A | PATENT ABSTRACTS OF JAPAN Bd. 0130, Nr. 79 (C-571), 22. Februar 1989 (1989-02-22) & JP 63 268773 A (TOYOBO CO LTD), 7. November 1988 (1988-11-07) * Zusammenfassung *<br>----- | 1,9, 13-16,22 | H05K H01L |
| A | EP 0 784 326 A (DU PONT) 16. Juli 1997 (1997-07-16)<br><br>* das ganze Dokument *<br>----- | 1,9,13, 15,16, 18,22 | |
| A | US 4 457 861 A (DESMARAIS JR RAYMOND C) 3. Juli 1984 (1984-07-03)<br>-----<br>-/-- | | |

Der vorliegende Recherchenbericht wurde für alle Patentansprüche erstellt

| Recherchenort | Abschlußdatum der Recherche | Prüfer |
|---|---|---|
| Berlin | 27. September 2004 | Visentin, A |

KATEGORIE DER GENANNTEN DOKUMENTE

X : von besonderer Bedeutung allein betrachtet
Y : von besonderer Bedeutung in Verbindung mit einer
      anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
      nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes
      Dokument

EPO FORM 1503 03.82 (P04C03)

**Europäisches Patentamt**

## EUROPÄISCHER RECHERCHENBERICHT

Nummer der Anmeldung

EP 04 00 5540

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | LENKEIT B ET AL COMMISSION OF THE EUROPEAN COMMUNITIES: "HIGH QUALITY SCREEN-PRINTED AND FIRED-THROUGH SILICON NITRIDE REAR CONTACTS FOR BIFACIAL SILICON SOLAR CELLS" 16TH. E.C. PHOTOVOLTAIC SOLAR ENERGY CONFERENCE. GLASCOW, UNITED KINGDOM, MAY 1 - 5, 2000, PROCEEDINGS OF THE INTERNATIONAL PHOTOVOLTAIC SOLAR ENERGY CONFERENCE, LONDON : JAMES & JAMES LTD, GB, Bd. VOL. 2 OF 3. CONF. 16, 1. Mai 2000 (2000-05-01), Seiten 1332-1335, XP001138888 ISBN: 1-902916-18-2 ----- | | |
| A | HORZEL J SIVOTHTHAMAN S ET AL COMMISSION OF THE EUROPEAN COMMUNITIES: "SCREEN-PRINTED RAPID THERMAL PROCESSED (RTP) SELECTIVE EMITTER SOLAR CELLS USING A SINGLE DIFFUSION STEP" 16TH. E.C. PHOTOVOLTAIC SOLAR ENERGY CONFERENCE. GLASCOW, UNITED KINGDOM, MAY 1 - 5, 2000, PROCEEDINGS OF THE INTERNATIONAL PHOTOVOLTAIC SOLAR ENERGY CONFERENCE, LONDON : JAMES & JAMES LTD, GB, Bd. VOL. 2 OF 3. CONF. 16, 1. Mai 2000 (2000-05-01), Seiten 1087-1090, XP001138826 ISBN: 1-902916-18-2 ----- | | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| Berlin | 27. September 2004 | Visentin, A |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.......................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 04 00 5540

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-09-2004

| Im Recherchenbericht angeführtes Patentdokument | | Datum der Veröffentlichung | Mitglied(er) der Patentfamilie | | | Datum der Veröffentlichung |
|---|---|---|---|---|---|---|
| WO 9324934 | A | 09-12-1993 | AU | 4339493 | A | 30-12-1993 |
| | | | EP | 0705479 | A1 | 10-04-1996 |
| | | | WO | 9324934 | A1 | 09-12-1993 |
| US 6322620 | B1 | 27-11-2001 | CN | 1354208 | A | 19-06-2002 |
| | | | EP | 1207726 | A2 | 22-05-2002 |
| | | | JP | 2002201395 | A | 19-07-2002 |
| | | | SG | 96262 | A1 | 23-05-2003 |
| US 6312864 | B1 | 06-11-2001 | JP | 11144619 | A | 28-05-1999 |
| | | | TW | 391033 | B | 21-05-2000 |
| | | | US | 6120975 | A | 19-09-2000 |
| EP 1119007 | A | 25-07-2001 | JP | 2001202822 | A | 27-07-2001 |
| | | | EP | 1119007 | A2 | 25-07-2001 |
| | | | US | 2001029977 | A1 | 18-10-2001 |
| JP 63268773 | A | 07-11-1988 | KEINE | | | |
| EP 0784326 | A | 16-07-1997 | US | 5653918 | A | 05-08-1997 |
| | | | DE | 69627622 | D1 | 28-05-2003 |
| | | | DE | 69627622 | T2 | 22-01-2004 |
| | | | EP | 0784326 | A2 | 16-07-1997 |
| | | | JP | 3358962 | B2 | 24-12-2002 |
| | | | JP | 9194659 | A | 29-07-1997 |
| | | | TW | 407284 | B | 01-10-2000 |
| US 4457861 | A | 03-07-1984 | US | 4327124 | A | 27-04-1982 |
| | | | US | 4421944 | A | 20-12-1983 |
| | | | US | 4429657 | A | 07-02-1984 |

EPO FORM P0461

Für nähere Einzelheiten zu diesem Anhang : siehe Amtsblatt des Europäischen Patentamts, Nr.12/82